# EUROPÄISCHE PATENTSCHRIFT

(11) **EP 2 002 379 B1**
(45) Veröffentlichungstag und Bekanntmachung des Hinweises auf die Patenterteilung: **16.05.2012**
(21) Anmeldenummer: 07711759.6
(22) Anmeldetag: 02.03.2007
(51) Int. Cl.: G06K 13/08, G06K 7/00, H05K 5/02, H01R 13/00, G11B 25/04

(54) **KARTENLESER NACH DEM PUSH-PUSH-SYSTEM**
CARD READER BASED ON THE PUSH-PUSH SYSTEM
LECTEUR DE CARTES SELON LE SYSTEME PUSH-PUSH

(30) Priorität: 31.03.2006 DE 102006015006
(43) Veröffentlichungstag der Anmeldung: 17.12.2008
(73) Patentinhaber: Amphenol-Tuchel Electronics GmbH, 74080 Heilbronn (DE)
(72) Erfinder: POGUNTKE, Matthias, 74080 Heilbronn (DE)
(74) Vertreter: Wagner, Karl H.
(86) Internationale Anmeldenummer: PCT/EP2007/001830
(87) Internationale Veröffentlichungsnummer: WO 2007/115609

(56) Entgegenhaltungen:
- DE-A1-102005 029 898
- US-A1- 2003 068 927
- US-A1- 2005 277 318

## Beschreibung

Die vorliegende Erfindung bezieht sich auf einen Kartenleser nach dem Push-Push-System. Vorzugsweise bezieht sich die Erfindung auf einen SIM-Kartenleser.

Bei einem Push-Push-System (PPS) sind im Wesentlichen die folgenden Bestandteile vorgesehen: eine Herzkurve, ein Schubelement, ein Führungselement und eine Feder. Die Herzkurve dient zur Definition der einzelnen Karteneinschubschritte, wie folgt:
1. Karte bis zum hinteren Anschlag in den Kartenleser einschieben.
2. Loslassen der Karte, wobei die Karte durch die Feder über das Schubelement und das Führungselement in die Ruheposition geschoben wird.
3. Karte wird zum Entnehmen erneut bis an den hinteren Anschlag eingedrückt.
4. Karte loslassen, worauf die Karte durch die Feder mittels Schubelement und Führungselement ausgeworfen wird.
5. Karte entnehmen.

Bei dem bekannten Push-Push-System ist also neben einem Schubelement ein Führungselement vorgesehen, wobei das eine Bauteil die Führung in Längsrichtung übernimmt, während das andere Bauteil die rotatorische Führung übernimmt. Bekanntlich resultiert die Rotation aus der Winkelbewegung des Schubelements in der Herzkurve.

Zum Stand der Technik sei auf die DE 10 2005 029 898 hingewiesen, die einen Kartenleser gemäß dem Oberbegriff des Anspruchs 1 zeigt. Kartenlesegeräte sind auch aus US 2003/0068927 und US 2005/0277318 bekannt.

Erfindungsgemäß wird ein Kartenleser gemäß Anspruch 1 vorgesehen, wobei bevorzugte Ausgestaltungen der Erfindung in den Unteransprüchen beansprucht sind.

Erfindungsgemäß ist zur Realisierung einer Höhenführung, einer Längsführung und auch einer rotatorischen Führung lediglich ein als Schubmodul bezeichnetes Bauteil vorgesehen, in dem die erforderlichen Führungsmittel integriert sind. Erfindungsgemäß ist dieses Schubmodul als ein Teil des erforderlichen Federlängslagers ausgebildet, wobei die Federführung in allen Richtungen integriert ist.

Vorzugsweise sind der Kartenanschlag sowie ein Federarm, welcher die durch die Herzkurve erforderliche Höhenbewegung ermöglicht, in dem Schubmodul integriert.

Bei Verwendung einer in Längsrichtung verlaufenden Feder, vorzugsweise einer Schraubenfeder, ist das erste bereits erwähnte Federlängslager am Schubmodul vorgesehen sein, während das zweite Federlängslager vorzugsweise durch den Deckel gebildet wird. Das zweite Federlängslager kann aber auch durch den Kontaktträger gebildet sein.

Bevorzugte Ausgestaltungen der Erfindung ergeben sich aus den abhängigen Ansprüchen.

Weitere Vorteile, Ziele und Einzelheiten der Erfindung ergeben sich aus der Beschreibung eines Ausführungsbeispiels anhand der Zeichnung; in der Zeichnung zeigt:
- Fig. 1: eine perspektivische Draufsicht auf den erfindungsgemäßen Kartenleser mit Deckel;
- Fig. 2: eine Draufsicht auf den Kartenleser gemäß Fig. 1, wobei der Deckel entfernt ist;
- Fig. 3: eine Draufsicht auf den Kartenleser gemäß Figuren 1 und 2, wobei der Deckel teilweise entfernt ist;
- Fig. 4: eine Einzelheit des Kartenlesers gemäß Fig. 2;
- Fig. 5: eine vergrößerte Darstellung der Herzanordnung gemäß Fig. 4;
- Fig. 6: eine perspektivische Draufsicht auf das erfindungsgemäße Schubmodul;
- Fig. 7: eine Draufsicht auf das Schubmodul mit eingesetzter Feder;
- Fig. 8: eine schematische Schnittansicht quer zur Einsteckrichtung in etwa im durch das Bezugszeichen 78 in Fig. 2 gekennzeichneten Bereich;
- Fig. 9: eine Ansicht ähnlich Fig. 8, wobei der Deckel aufgesetzt ist;
- Fig. 10: eine Draufsicht auf einen Teil des Kartenlesers bei entferntem Deckel;
- Fig. 11: eine Einzelheit des Kartenlesers bei sich in der Lesestellung befindlicher Karte;
- Fig. 12: eine perspektivische Draufsicht zur Veranschaulichung der Längslagerung der Feder einerseits am Schubmodul und andererseits am Deckel.

Alle Figuren beziehen sich auf einen Kartenleser 10, der allgemein nach dem Push-Push-System (PPS) 20, speziell aber nach dem Push-Push-Schubsystem 22, arbeitet.

Das Push-Push-System verwendet bekanntermaßen einen noch zu beschreibende Herzkurvenanordnung 21, die im Folgenden noch erläutert wird.

Der erfindungsgemäße Push-Push-Kartenleser 10 ist vorzugsweise, wie dargestellt, ein SIM-Kartenleser. Die erfindungsgemäßen Maßnahmen sind aber auch bei einem Kartenleser für andere Smart-Karten oder Chip-Karten geeignet.

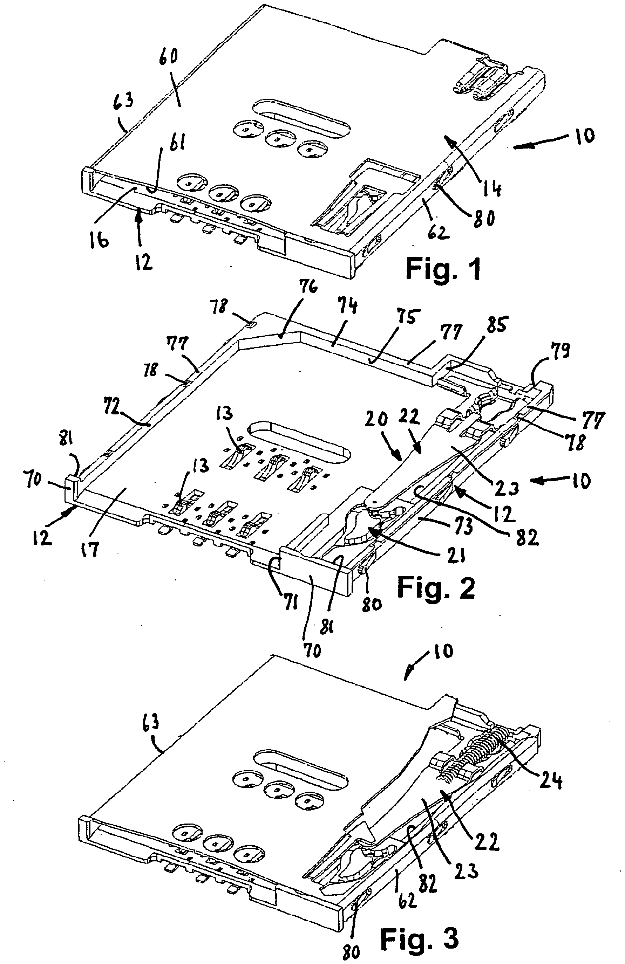

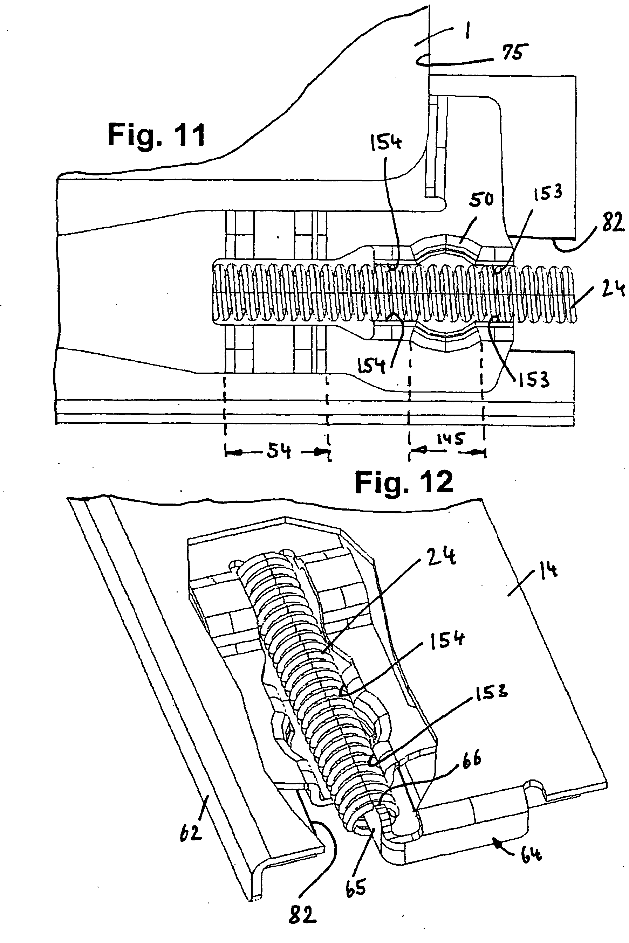

Der Kartenleser 10 weist einen Kontaktträger 12 auf, in dem - vgl. Fig. 2 - Kontakte 13, beispielsweise Lesekontakte 13, angeordnet sind, die die Kontaktflächen der SIM-Karte 1 (vgl. Fig. 11) in Kontakt gebracht werden können, wenn sich die Karte 1 in der Lesestellung befindet.

Der sozusagen oben offene Kontaktträger 12 ist mit einem Deckel 14 abgeschlossen. Zwischen einer Unterseite 61 des Deckels 14 und einer von der Oberseite des Kontaktträgers 12 gebildeten Kartenauflagefläche 17 wird ein Kartenaufnahmeschacht 16 gebildet, in dem die Karte 10 durch Einschieben (push) einsetzbar und bis in ihre Lesestellung entgegen der Kraft von noch zu beschreibenden Federmitteln, z.B. Feder 24 bewegbar ist. Um die Karte 1 aus der Lesestellung auszustoßen bzw. zu entnehmen, erfolgt nach dem Push-Push-Schubsystem 22 ein kurzzeitiges Drücken auf die entgegengesetzt zur Einsetzrichtung liegende "hintere" Kartenkante, um zu bewirken, dass die Karte 1 aus der Lesestellung heraus in eine Entnahmestellung bewegt oder ausgeworfen wird.

### Das Push-Push-Schubsystem 22

Das Push-Push-System 20 ist im Allgemeinen bekannt und verwendet - vgl. dazu Fig. 2 - das eine Herzkurve aufweisende Herzkurvensystem 21. Zusätzlich zum Herzkurvensystem 21 verwenden bekannte Push-Push-Schubsysteme ein Schubelement und ein Führungselement.

Erfindungsgemäß ist nun das Push-Push-Schubsystem 22 derart ausgebildet, dass ein integriertes Schubmodul 23, 24 vorgesehen wird, welches ein Schubelement 23 sowie vorzugsweise darin integrierte Federmittel bzw. eine Feder 24 aufweist.

### Das Herzkurvensystem 21

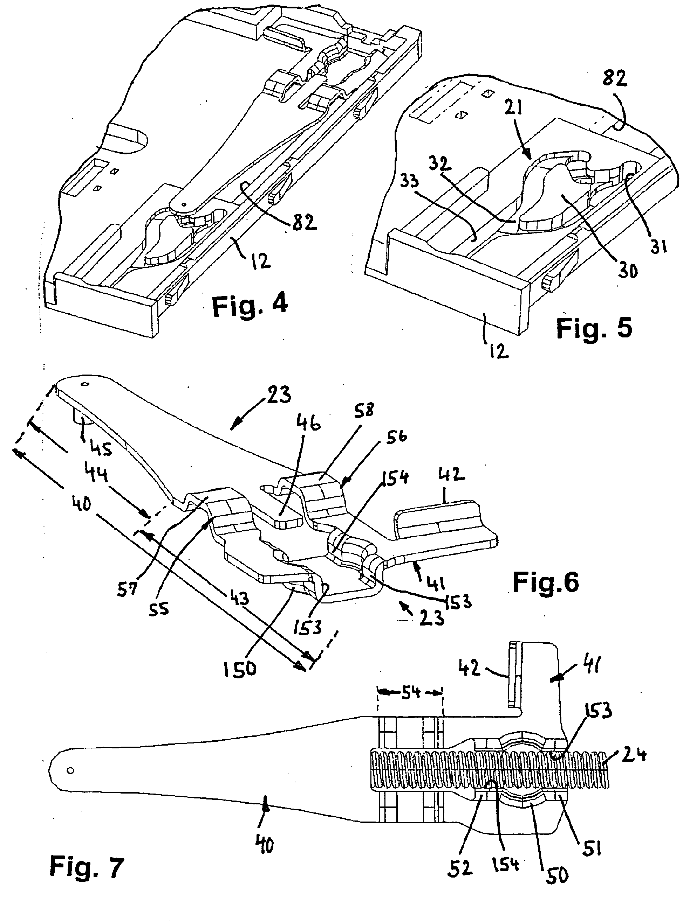

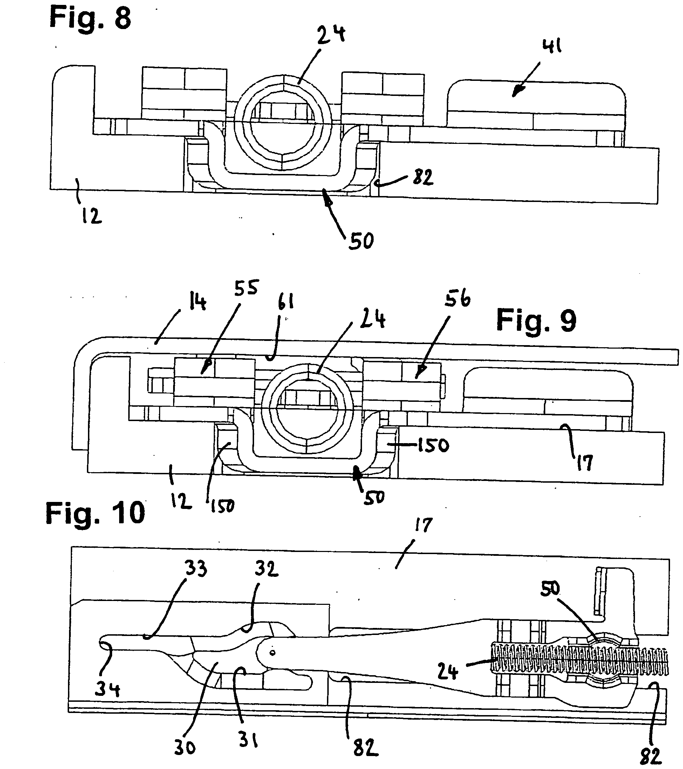

Obwohl Herzkurvensysteme von der Art des hier gezeigten Herzkurvensystems 21 aus dem Stand der Technik wohl bekannt sind, sei hier noch unter Bezugnahme auf Fig. 5 ausgeführt, dass das Herzkurvensystem 21 ein herzförmiges Führungselement 30 aufweist. In etwa in Karteneinsteckrichtung verlaufende Führungskanäle 31, 32 sind beidseitig zum Führungselement 30 angeordnet, und sind mit einem entgegen der Einsteckrichtung verlaufenden gradlinigen Führungskanal 33 verbunden, der ein Anschlagende 34 (Fig. 10) aufweist. Am entgegengesetzten Ende bilden die Führungskanäle 31, 32 die erforderlichen Rast- und Führungsflächen zur Erreichung des Push-Push-Betriebs. Wie man beispielsweise in Fig. 5 erkennt, liegen die Führungskanäle 31, 32 auf verschiedenen Höhen, was bei der Konstruktion eines Push-Push-Schubsystems, und insbesondere auch des erfindungsgemäßen Push-Push-Schubsystems 22, berücksichtigt werden muss.

### Das Schubmodul 23, 24

Das Schubmodul 23, 24 ist beispielsweise in den Figuren 6 bis 12 im Einzelnen veranschaulicht.

Das bereits erwähnte Schubelement 23 - vgl. dazu Fig. 6 - weist einen langgestreckten Führungsarm 40 sowie einen kürzeren, vorzugsweise senkrecht zum Führungsarm 40 verlaufenden Anschlagarm 41 auf, der einen Kartenanschlag- bzw. eine Kartenanschlagfläche 42 bildet.

Der Führungsarm 40 besitzt einen auch als Federarm 44 bezeichneten Führungsabschnitt, an dessen einen Ende ein Zapfen 45 nach unten ragend befestigt ist. Ferner weist der Führungsarm 40 einen Lagerabschnitt 43 auf, der verschiedene Lagermittel bildet, und zwar für die rotatorische Führung bzw. Lagerung, für die Längsführung bzw. -lagerung und auch für die Höhenführung bzw. -lagerung.

Im Einzelnen sind - vgl. dazu insbesondere die Figuren 6 und 11 - ein erster U-förmiger Abschnitt 51 und ein zweiter U-förmiger Abschnitt 52 vorgesehen. Die ersten und zweiten U-förmigen Abschnitte 51, 52 bilden jeweils als seitliche Federlager 153 bzw. 154 bezeichnete Federauflageflächen.

Ferner weist der Lagerabschnitt 43 einen Höhenlagerabschnitt 54 auf, der durch zwei beabstandete Höcker 55, 56 gebildet wird. Die Höcker 55, 56 bilden an oberen, vorzugsweise eben verlaufenden Lagerflächen jeweils Höhenführungen 57 bzw. 58. Diese Höhenführungen bzw. Lagerflächen 57, 58 stehen bei fertig montiertem Kartenleser 10 mit einer Unterseite 61 des Deckels 14 in Berührung.

Der Lagerabschnitt 43 weist ferner neben den beiden im Querschnitt U-förmigen Federführungsabschnitten 51, 52 einen Dreh- und Längsführungsabschnitt 145 (Fig. 11) auf. Dieser Dreh- und Längsführungsabschnitt 145 sieht eine rotatorische und Längsführung vor und gestattet auch eine gewisse Höhenbewegung für das gesamte Schubelement 23. Der Dreh- und Längsführungsabschnitt 145 bildet einen Drehzapfen 50, dadurch dass Teile des das Schubelement 23 vorzugsweise bildenden Metallblechs nach unten gepresst sind, wie dies in Fig. 6 gezeigt ist. Dadurch werden beidseitig äußere Lagerflächen 150 gebildet, die mit Führungs- oder Lagerflächen, gebildet von einer Führungsnut 82, im Kontaktträger 12 - vgl. z.B. Fig. 2 - in Gleitberührung stehen.

Federmittel, insbesondere eine Feder, vorzugsweise eine Schraubenfeder 24 sind bzw. ist praktisch in dem Schubelement 23 integriert, und sitzt zum einen mit ihrem einen Ende auf einer ein Federlängslager bildende Zunge 46, die im Bereich des Höhenlagerabschnitts 54 in einer Ausnehmung zwischen den Buckeln 57, 58 verläuft. Zum anderen ist die Feder 24 mit ihrem anderen Ende am ein weiteres Federlängslager bildenden Kontaktträger abgestützt. Gemäß dem gezeigten bevorzugten Ausführungsbeispiel ist das weitere Federlängslager am Deckel ausgebildet.

Das Schubelement 23 ist, wie erwähnt, vorzugsweise aus einem Metallblech hergestellt und wird in die in Fig. 6 gezeigte Form gestanzt und gepresst.

Der Deckel 14 ist vorzugsweise aus Metallblech hergestellt und weist neben der bereits erwähnten Unterseite 61 eine Oberseite 60 auf, sowie beabstandete Seitenwände 62, 63, die mit Öffnungen ausgestattet sind, um so mit vom Kontaktträger 12 gebildeten Rastnocken 80 in Eingriff zu kommen. Der Deckel 14 besitzt ferner vorzugsweise eine Rückwand 64, die nicht über die ganze Rückseite des Kontaktträgers 12 verlaufen muss, sondern wie in Fig. 12 gezeigt, beispielsweise nur über einen Teil der Rückseite hinweg verläuft, dabei zusätzlich aber einen Federhaltesteg 65 für die Feder 24 bildet. Der Federhaltesteg 65 besitzt einen Federanschlag 66, an dem die Schraubenfeder 24 mit ihrem einen Ende anliegt. Wie bereits erwähnt, könnte ein Federanschlag für dieses Ende der Feder 24 auch vom Kontaktträger gebildet werden.

### Der Kontaktträger 12

Der Kontaktträger 12 besitzt, wie insbesondere in Fig. 2 gezeigt ist, beidseitig kurze Vorderwandteile 70, die eine Öffnung 71 zum Kartenaufnahmeschacht 16 ermöglichen. Ferner besitzt der Kontaktträger 12 beabstandet angeordnete Seitenwände 72 und 73, die durch eine Rückwand 74 verbunden sind. Die Rückwand 74 bildet eine erste Kartenanschlagfläche 75, an die sich eine abgeschrägte Anschlagfläche 76 anschließt. Die Seitenwände 72, 73 sowie die Rückwand 74 besitzen eine auf gleicher Höhe liegende Oberkante 77, auf der der Deckel 16 mit einer Unterseite 61 aufliegt. Auf der Oberkante 77 sind Nocken 78 nach oben ragend vorgesehen.

Die eine Ausbuchtung 85 für die Aufnahme des Anschlagarms 41 bildende Rückwand 74 besitzt eine Ausnehmung 79, durch die hindurch der Federhaltesteg 65 verlaufen kann. Die Vorderwandteile 70 bilden Anschlagkanten 81 zur Halterung der Vorderkante des Deckels 60.

Der Kontaktträger 12 ist vorzugsweise aus Kunststoff hergestellt, und insbesondere durch Spritzguss.

Sämtliche Darstellungen der Figuren zeigen den erfindungsgemäßen SIM-Kartenleser 10 in einer Betriebsstellung bei eingesetzter, sich in Lesestellung befindlicher SIM-Karte 1, wobei aber wie bemerkt die SIM-Karte 1 nur in Fig. 11 zu sehen ist. In der Lesestellung der SIM-Karte 1 sind, wie in Fig. 11 gezeigt, die Anlageflächen 75 am Kontaktträger und die Anlagefläche oder der Kontaktanschlag 42 des Schubelements 23 ausgerichtet.

Bei nicht eingesetzter Karte 1 ist das Schubelement 23 durch die Feder 24 entgegen der Einsetzrichtung der Karte 1 vorgespannt, d.h. der Zapfen 45 liegt unter Federdruck an dem Anschlagende 34 an. Wenn eine Karte in den Kartenschacht 16 eingesetzt wird, und bis zum Auftreffen auf den Kartenanschlag 42 verschoben wird, so wird bei weiterem Druck auf die Karte 1 (erster Push) das Schubelement 23 in Karteneinsteckeinrichtung verschoben, wobei der Zapfen durch die Führungsbahn 32 läuft, und schließlich entsprechend der in Gestaltung des Herzkurvensystems 21 auf der Herzkurve an der Raststelle einrastet. Bei dieser Einraststellung des Schubelements 23 befindet sich die Karte 1 in ihrer Lesestellung.

Wenn nochmals (zweiter Push) auf das hintere Kartenende gedrückt wird, so wird der Zapfen aus der Raststellung herausgehoben, und die Feder 24 drückt und verschiebt das Schubelement 23 entgegen der Karteneinsetzrichtung und zwar zusammen mit der an dem Kartenanschlag 42 anliegenden Karte 1 entgegen der Einsteckrichtung aus dem Kartenschacht heraus.

## Patentansprüche

1. Kartenleser (10) mit
einem Kontakte (13) aufweisenden Kontaktträger (12),
einem am Kontaktträger (12) befestigten Deckel (14) zur Bildung eines Aufnahmeschachtes (16) für eine in den Schacht (16) in einer Karteneinführrichtung einsetzbare Karte (1)
und mit einem Push-Push-System (20),
welches ein eine Herzkurvenanordnung (21) und ein Federmittel aufweisendes Push-Push-Schubsystem (22) verwendet,
und das Einsetzen und die Entnahme der Karte derart ermöglicht,
dass auf das dem Einsetzende der Karte (1) entgegengesetzte Ende der einzusetzenden Karte (1) durch einen ersten Push in den Kartenleser (10) gedrückt wird, um in der Lesestellung zu verbleiben,
und wobei zur Entnahme der Karte (1) wiederum auf das aus dem Kontaktträger herausragende entgegengesetzte Ende der Karte (1) durch einen zweiten Push gedrückt wird, um ein automatisches Herausschieben der Karte (1) mittels des Push-Push-Schubsystems (22) zum Zwecke der Entnahme der
Karte zu gestatten,
**dadurch gekennzeichnet, dass**
das Push-Push-Schubsystem (20)
ein einteiliges,
in Karteneinführrichtung verschiebbares einteiliges Schubmodul (23, 24) aufweist, welches bezüglich der Karteneinführrichtung in einer Schwenkrichtung verschwenkbar und auch in Höhenrichtung, d. h. senkrecht zu den Karteneinführ- und Schwenk-Richtungen, verschwenkbar ist
und welches beim Einführen durch den ersten Push der Karte (1) in den Kartenleser (10) durch die Karte kontaktiert oder berührt und in Einführrichtung verschoben, seitlich sowie höhenmäßig verschwenkt wird, und
am Ende der Einsetzbewegung in der Lesestellung der Karte (1) verriegelt wird, und
wobei bei einem darauffolgenden Push die Verriegelung des einteiligen Schubmoduls (23, 24) in der im Kontaktträger (12) ausgebildeten Herzkurvenanordnung (21) gelöst wird und das einteilige Schubmodul (23, 24) die Karte (1) aus der Lesestellung herausschiebt, so dass die Karte aus dem Kartenleser (10) entnommen werden kann.

2. Kartenleser nach Anspruch 1, wobei das Schubelement (23), 24 ein einziges Schubelement (23) aufweist, welches im Kartenschacht bzw. benachbart zum Kartenschacht gelagert ist und zwar in Karteneinschubrichtung längsverschiebbar und gleichzeitig auch in Querrichtung, das heißt seitlich sowie in Höhenrichtung verschwenkbar.

3. Kartenleser nach Anspruch 2, wobei das Schubelement (23) einen Führungsarm (40) und in etwa quer dazu verlaufend einen Anschlagarm (41) mit einem Kartenanschlag (42) aufweist.

4. Kartenleser nach Anspruch 3, wobei der Führungsarm (40) einen Führungsabschnitt (44) aufweist, der als ein Federarm wirkt, und ferner einen Lagerabschnitt (43) um das Schubelement (23) rotatorisch, d.h. für eine Schwenkbewegung und auch für eine Längsbewegung zu lagern.

5. Kartenleser nach Anspruch 4, wobei der Lagerabschnitt (43) einen Zapfen (50) aufweist, und zwar zur Translations- und Schwenklagerung in einer Führungsnut (82), ausgebildet im Kontaktträger (12).

6. Kartenleser nach Anspruch 4 oder 5, wobei der Lagerabschnitt (43) erste und zweite im Ganzen U-förmige Abschnitte (51, 52) aufweist, die seitliche Federlager bzw. Federauflageflächen (153 bzw. 154) bilden.

7. Kartenleser nach einem der vorhergehenden Ansprüche, wobei die Feder (24) einerseits in einem Raum zwischen zwei von einem Führungsabschnitt (44) gebildeten Höckern (55, 56) angeordnet ist, und auf einer Zunge (46) sitzt, die sich in den zwischen den Höckern (55, 56) gebildeten Zwischenraum erstreckt.

8. Kartenleser nach Anspruch 6, wobei die Feder (24) in einem Raum, gebildet von den Federauflageflächen (153, 154), eingesetzt ist und darin verläuft, und sich mit ihrem anderen Ende an einem Gegenlager, ausgebildet am Kontaktträger oder am Deckel, abstützt.

9. Kartenleser nach Anspruch 7, wobei die Abstützung der Feder (24) mit ihrem einen Ende am Führungsschnitt oder. Federarm (44) erfolgt, während die entgegengesetzte Abstützung der Feder (24) an einem Federhaltesteg (65), gebildet vom Deckel (14), vorgesehen ist.

10. Kartenleser nach Anspruch 9, wobei der Federhaltesteg (65) an einer Rückwand (64) des Deckels (14) ausgebildet ist und einen Federanschlag (66) aufweist.

11. Kartenleser nach Anspruch 2, wobei das Schubelement die rotatorische Führung, die Höhenführung und die Längsführung zusammen mit Kartenanschlag und Federführung sowie Federhalterung integriert aufweist.

## Claims

1. A card reader (10) comprising:
a contact support (12) adapted to support contacts (13),
a cover (14) mounted on the contact support (12) and forming a receiving space (16) for a card (1), said card (1) being adapted for insertion into said receiving space (16) in a card insert direction; and
a push-push system (20),
said push-push system (20) comprising a heart-shaped curve design (21) and a push-push module system (22) using spring means, said push-push module system being designed such that the card can be inserted into and removed from the card reader,
wherein for insertion into the card reader (10) a first push is applied to the rear end (the end opposite to the insert end of the card (1)) such that the card remains in the reading position, and
wherein for the removal of the card (1) a second push is applied again against the rear end of the card (1),
such that the card (1) is automatically removed by means of the push-push module system (22) for the purpose of taking the card out of the card reader,
**characterized in that** the push-push module system (20) comprises an integral push module (23, 24),
said push module (23, 24) being pivotable with respect to the direction of insertion of the card and also in an elevational direction, i.e. perpendicular to the card insert direction and pivot directions, and
wherein said push module (23, 24) which is contacted by the card (1) during insertion by the first push, is moved by said card into the direction of insertion with the push module being laterally and elevationally pivoted, and
wherein at the end of the insert movement, the card (1) is locked in the reading position, and
wherein a subsequent push releases the locking of the push module (23, 24) in the heart-shaped curve arrangement (21) and the push module (23, 24) moves the card out of the reading position so that the card can be taken out of the card reader (10).

2. Card reader as set forth in claim 1 wherein the push element (23, 24) comprises a single push element (23) which is supported in the card receiving space or adjacent to the card receiving space and which is longitudaly movable in the direction of card insertion and also in transverse direction, i.e. the push module is laterally as well as elevationally pivotable.

3. The card reader of claim 2, wherein the push element (23) comprises a guide arm (40) and, in substance transversely thereto, an abutment arm (41) having a card abutment (42).

4. The card reader according to claim 3, wherein the guide arm (40) comprises a guide section (44) which acts as a spring arm and further comprises a support section (43) so as to support the push element (23) for pivotable movement both for a pivotal motion and a longitudinal motion.

5. The card reader according to claim 4, wherein the support section (43) comprises a pin (50) for providing the translational and pivotal mounting within a guide groove (82) which is provided in the contact support (12).

6. The card reader of claim 4 or 5, wherein the support section (43) comprises first and second generally U-shaped sections (51, 52) which form lateral spring support surfaces (153, 154).

7. The card reader according to one or more of the preceding claims, wherein the spring (24) is located with one end in a space provided between two projections (55, 56) formed by the guide section (44) and wherein said spring (24) is located on a tongue (46) which extends into the space between the projections.

8. The card reader according to one or more of the preceding claims, wherein the spring (24) is inserted into a space formed by the spring abutment surfaces (153, 154) and is supported with the other end at an opposite support formed at the contact support or the cover.

9. The card reader according to one or more of the preceding claims, wherein the support of the spring (24) with its one end is provided at the guide section or the spring arm (44), while the opposite support of the spring (24) is provided at a spring holding rib (65) formed by the cover (14).

10. The card reader according to one of the preceding claims, wherein the spring holding rib (65) is formed at a rear wall (64) of the cover (14) and comprises a spring abutment (66).

11. The card reader according to one or more of the preceding claim, wherein the push element integrally comprises the pivotal support, the elevational support and the longitudinal support together with the card abutment, the spring guidance and the spring mounting.

## Revendications

1. Lecteur de cartes (10) comprenant :
un support de contacts (12) adapté à supporter des contacts (13),
un couvercle (14) monté sur le support de contacts (12) et formant un espace de réception (16) pour une carte (1), la carte (1) étant adaptée à une insertion dans l'espace de réception (16) dans une direction d'insertion de carte ; et
un système pousser-pousser (20),
le système pousser-pousser (20) comprenant un agencement en courbe à forme de coeur (21) et un système de module pousser-pousser (22) utilisant des moyens de ressort, le système de module pousser-pousser étant conçu de telle sorte que la carte peut être insérée et retirée du lecteur de cartes,
dans lequel pour l'insertion dans le lecteur de cartes (10) on applique une première poussée sur l'extrémité arrière (l'extrémité opposée à l'extrémité d'insertion de la carte (1)) de telle sorte que la carte reste dans la position de lecture, et
dans lequel, pour le retrait de la carte (1), on applique de nouveau une deuxième poussée sur l'extrémité arrière de la carte (1),
de sorte que la carte (1) est retirée automatiquement au moyen du système de module pousser-pousser (22) dans le but de retirer la carte du lecteur,
**caractérisé en ce que** le système de module pousser-pousser (20) comprend un module de poussée d'une seule pièce (23, 24),
le module de poussée (23, 24) pouvant pivoter par rapport à la direction d'insertion de la carte et aussi dans une direction d'élévation, c'est-à-dire perpendiculairement à la direction d'insertion de la carte et à la direction de pivotement, et
dans lequel le module de poussée (23, 24) qui est contacté par la carte (1) pendant l'insertion par la première poussée, est déplacé par la carte dans la direction d'insertion pendant que le module de poussée pivote latéralement et dans la direction d'élévation, et
dans lequel, à la fin du mouvement d'insertion, la carte (1) est verrouillée dans la position de lecture, et
dans lequel une poussée ultérieure libère le verrouillage du module de poussée (23, 24) dans l'agencement en courbe à forme de coeur (21) et le module de poussée (23, 24) déplace la carte pour la faire sortir de la position de lecture de telle sorte que la carte peut être retirée du lecteur de cartes (10).

2. Lecteur de cartes selon la revendication 1, dans lequel l'élément de poussée (23, 24) comprend un élément à poussée unique (23) qui est supporté dans l'espace de réception de carte ou à côté de l'espace de réception de carte et qui est mobile longitudinalement dans la direction de l'insertion de carte et aussi dans la direction transversale, c'est-à-dire que le module de poussée peut être pivoté aussi bien latéralement que dans la direction d'élévation.

3. Lecteur de cartes selon la revendication 2, dans lequel l'élément de poussée (23) comprend un bras de guidage (40) et, sensiblement transversalement à celui-ci, un bras de butée (41) comportant une butée de carte (42).

4. Lecteur de cartes selon la revendication 3, dans lequel le bras de guidage (40) comprend une section de guidage (44) qui sert de bras à ressort et comprend en outre une section de support (43) afin de supporter l'élément de poussée (23) pour un mouvement pivotant à la fois pour un mouvement de pivotement et un mouvement longitudinal.

5. Lecteur de cartes selon la revendication 4, dans lequel la section de support (43) comprend une broche (50) pour assurer le montage en translation et en pivotement dans une gorge de guidage (82) qui est prévue dans le support de contacts (12).

6. Lecteur de cartes selon la revendication 4 ou 5, dans lequel la section de support (43) comprend des premières et deuxièmes sections en forme générale de U (51, 52) qui forment des surfaces de support latéral de ressort (153, 154).

7. Lecteur de cartes selon une ou plusieurs des revendications précédentes, dans lequel le ressort (24) est placé avec une extrémité dans un espace prévu entre deux protubérances (55, 56) formées par la section de guidage (44) et dans lequel le ressort (24) est placé sur une languette (46) qui s'étend dans l'espace entre les protubérances.

8. Lecteur de cartes selon une ou plusieurs des revendications précédentes, dans lequel le ressort (24) est inséré dans un espace formé par les surfaces de butée de ressort (153, 154) et est supporté par son autre extrémité au niveau d'un support opposé formé au niveau du support de contacts ou du couvercle.

9. Lecteur de cartes selon une ou plusieurs des revendications précédentes, dans lequel le support du ressort (24) par sa première extrémité est prévu au niveau de la section de guidage ou du bras à ressort (44), tandis que le support opposé du ressort (24) est prévu au niveau d'une nervure de maintien de ressort (65) formée par le couvercle (14).

10. Lecteur de cartes selon une des revendications précédentes, dans lequel la nervure de maintien de ressort (65) est formée au niveau d'une paroi arrière (64) du couvercle (14) et comprend une butée de ressort (66).

11. Lecteur de cartes selon une ou plusieurs des revendications précédentes, dans lequel l'élément de poussée comprend en une seule pièce le support de pivotement, le support d'élévation et le support longitudinal avec la butée de carte, le guidage du ressort et le montage du ressort.
